# EUROPEAN PATENT SPECIFICATION

(11) **EP 2 119 754 B1**
(45) Date of publication and mention of the grant of the patent: **30.11.2011**
(21) Application number: 09251290.4
(22) Date of filing: 11.05.2009
(51) Int. Cl.: C09K 11/06, H05B 33/14, C08L 83/08, C08G 65/00, C08L 71/00, H01L 23/29

(54) **Light-emitting device**
Lichtemittierende Vorrichtung
Dispositif électroluminescent

(30) Priority: 15.05.2008 JP 2008127802
(43) Date of publication of application: 18.11.2009
(73) Proprietor: Shin-Etsu Chemical Co., Ltd., Tokyo (JP)
(72) Inventor: Koshikawa, Hidenori, Annaka-shi, Gunma-ken (JP); Shiono, Mikio, Annaka-shi, Gunma-ken (JP)
(74) Representative: Stoner, Gerard Patrick

(56) References cited:
- EP-A2- 0 676 450
- EP-A2- 2 043 147
- US-A1- 2006 159 937

## Description

### TECHNICAL FIELD

This invention relates to a light-emitting device having an LED chip embedded in resin.

### BACKGROUND

The light-emitting diode (LED) is a light-emitting member having many advantages including low power consumption, small size, light weight and long life. Since the latest development of blue emission GaN-based LED, active research works have been focused on LEDs. In particular, since the advent of white color LEDs having blue LEDs combined with YAG phosphors, LEDs find a spreading application as an energy-saving light source of the next generation.

Light-emitting devices using LED as a light source include lamp, surface mount and other types. In either type, LEDs are encapsulated in resins for protection against external impacts, dust, heat, moisture and other elements. As the encapsulating resin, epoxy resins have long been used in the art and nowadays, silicone resins are employed. See JP-A 10-228249 and JP 2927279

The document US 2006/0159937 discloses a light-emitting device comprising a light-emitting diode embedded in a resin encapsulant, the resin encapsulant being a cured product of a curable composition comprising (A) a linear polysiloxane compound having at least two alkenyl groups in the molecule; (B) a organohydrogensiloxane having at least two silicon-bonded hydrogen atoms in the molecule in an amount to give 0.5 to 3.9 moles of SiH groups per mole of alkenyl groups in component (A), (C) 0.1 to 50 ppm calculated as platinum group metal of a platinum group metal catalyst.

Light-emitting devices are used in a wide variety of applications including outdoor and indoor full color display panels, traffic signals, LC backlight in mobile phones and digital cameras, and substitutes for compact bulbs such as incandescent lamps and halogen lamps. In particular, the automobile-mounted application tends to expose light-emitting devices to corrosive gas atmospheres such as gaseous sulfur compounds, nitrogen oxides, COx, and chlorides. As these gases attack the epoxy and silicone resin encapsulants on LED, the emission intensity of light-emitting devices is eventually reduced.
Citation list
Patent Document 1: JP-A H10-228249
Patent Document 2: JP 2927279

It would be desirable to provide a light-emitting device comprising a light-emitting diode encapsulated with a resin wherein the encapsulating resin is not degraded even in the presence of corrosive acidic or basic gases such as gaseous sulfur compounds and nitrogen oxides, so that the device may maintain its emission intensity.

The inventors have found that a cured product of a curable composition comprising (A) a linear polyfluoro compound having at least two alkenyl groups in the molecule and a perfluoropolyether structure in the backbone, (B) a fluorinated organohydrogensiloxane having at least two silicon-bonded hydrogen atoms in the molecule, (C) a platinum group metal catalyst, and (D) a silica powder having a BET specific surface area of 50 to 400 m²/g is resistant against attacks of corrosive acidic or basic gases such as gaseous sulfur compounds and nitrogen oxides, and that light-emitting devices encapsulated with such compositions may maintain emission without loss of intensity.

The invention provides a light-emitting device comprising a light-emitting diode embedded in a resin encapsulant. The resin encapsulant is a cured product of a curable composition comprising
(A) 100 parts by weight of a linear polyfluoro compound having at least two alkenyl groups in the molecule and a perfluoropolyether structure in the backbone,
(B) a fluorinated organohydrogensiloxane having at least two silicon-bonded hydrogen atoms in the molecule in an amount to give 0.5 to 3.0 moles of SiH groups per mole of alkenyl groups in component (A),
(C) 0.1 to 500 ppm calculated as platinum group metal of a platinum group metal catalyst, and
(D) 0.01 to 10 parts by weight of a silica powder having a specific surface area of 50 to 400 m²/g as measured by the BET method.

The curable composition may further comprise (E) an organosilane or organosiloxane having at least one monovalent perfluoroalkyl, monovalent perfluorooxyalkyl, divalent perfluoroalkylene or divalent perfluorooxyalkylene group and at least one silicon-bonded hydroxyl and/or alkoxy group in the molecule, in an amount of 1 to 30 parts by weight per 100 parts by weight of the silica powder (D).

The curable composition may further comprise (F) 0.01 to 5.0 parts by weight of an organosilicon compound having at least one epoxy group and/or silicon-bonded alkoxy group in the molecule. In a preferred embodiment, the organosilicon compound (F) has at least one monovalent perfluoroalkyl, monovalent perfluorooxyalkyl, divalent perfluoroalkylene group or divalent perfluorooxyalkylene in the molecule.

The curable composition may further comprise (G) 0.1 to 10 parts by weight of an organosiloxane having in the molecule at least one silicon-bonded hydrogen atom and at least one epoxy group and/or trialkoxysilyl group bonded to a silicon atom via carbon atoms or carbon and oxygen atoms. In a preferred embodiment, the organosiloxane (G) has at least one monovalent perfluoroalkyl or perfluorooxyalkyl group bonded to a silicon atom via carbon atoms or carbon and oxygen atoms.

In a preferred embodiment, the linear polyfluoro compound (A) contains 0.002 to 0.3 mol/100 g of alkenyl. Typically component (A) is a linear polyfluoro compound having the general formula (1). 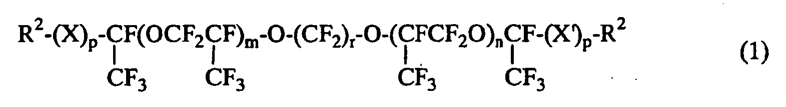 Herein X is a group: -CH₂- , -CH₂O- , -CH₂OCH₂- or -Y-NR¹-CO- wherein Y is -CH₂- or o-, m- or p-silylphenylene of the following structural formula (2): 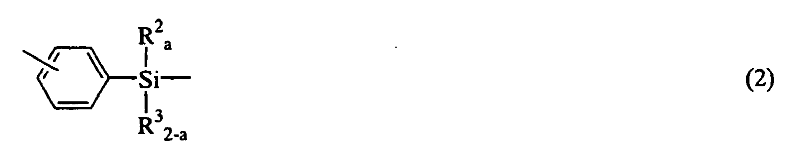 (wherein R² is alkenyl, R³ is hydrogen or a substituted or unsubstituted, monovalent hydrocarbon group which does not contain an aliphatic unsaturated bond, and "a" is 0, 1 or 2) and R¹ is hydrogen or a substituted or unsubstituted, monovalent hydrocarbon group; X' is a group: -CH₂-, -OCH₂-, -CH₂OCH₂- or -CO-NR¹-Y'- wherein Y' is -CH₂- or o- , m- or p-silylphenylene of the following structural formula (3): 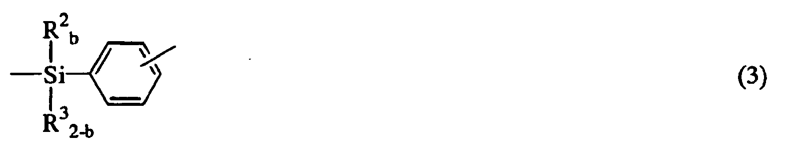 (wherein R² and R³ are as defined above, and "b" is 0, 1 or 2) and R¹ is as defined above; p is independently 0 or 1, r is an integer of 2 to 6, m and n each are an integer of 1 to 90, the sum of m and n is 2 to 180.

In a preferred embodiment, the fluorinated organohydrogensiloxane (B) has at least one monovalent perfluoroalkyl, monovalent perfluorooxyalkyl, divalent perfluoroalkylene or divalent perfluorooxyalkylene group in the molecule.

### Advantageous Effects

We find that light-emitting devices as proposed herein can maintain emission capability without loss of intensity or luminance, even in the presence of corrosive acidic or basic gases such as sulfur compound and nitrogen oxide gases.

### BRIEF DESCRIPTION OF DRAWINGS

These and other features, aspects, and advantages of the present invention will become better understood when the following detailed description is read with reference to the accompanying drawings in which like characters represent like parts throughout the drawings, wherein:
FIG. 1 is a schematic cross-sectional view of a light-emitting device according to one embodiment of the invention.
FIG. 2 is a schematic cross-sectional view of a light-emitting device according to another embodiment of the invention.

### FURTHER EXPLANATIONS; OPTIONS AND PREFERENCES

Throughout the specification, Me denotes methyl, Ph denotes phenyl, and "phr" refers to parts by weight of a certain component per 100 parts by weight of component (A).

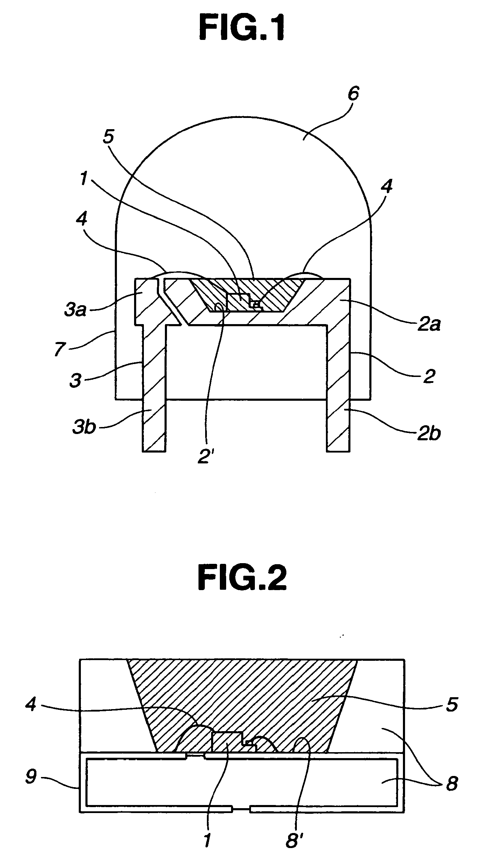

A light-emitting device of the invention is typically configured to cross-sectional structures as shown in FIGS. 1 and 2.

One embodiment of the light-emitting device is illustrated in FIG. 1 as comprising an LED chip 1, first and second leadframes 2 and 3, and bonding wires 4. LED chip 1 has one electrode at its bottom and another electrode at its top though the electrodes are not shown. First and second leadframes 2 and 3 include distal portions 2a and 3a and lead portions 2b and 3b, respectively. The distal portion 2a of first leadframe 2 is provided with a recess 2' of an inverted frustoconical shape having an increasing diameter from the bottom to the top. LED chip 1 is secured to the bottom of recess 2' by die bonding with for example silver paste so that one electrode of LED chip 1 is electrically connected to first leadframe 2. The other electrode of LED chip 1 is electrically connected to distal portion 3a of second leadframe 3 via bonding wire 4.

The recess 2' in first leadframe 2 is filled and sealed with a resin encapsulant 5 which is obtained by curing the curable composition of the invention.

The device further includes a light transmissive resin enclosure 7 which encloses and seals LED chip 1, distal portion 2a and an upper part of lead portion 2b of first leadframe 2, and distal portion 3a and an upper part of lead portion 3b of second leadframe 3. An upper portion of resin enclosure 7 forms a convex lens 6. Lower parts of lead portions 2b and 3b of first and second leadframes 2 and 3 extend outward of resin enclosure 7.

Another embodiment of the light-emitting device is illustrated in FIG. 2 as comprising an LED chip 1 and a package substrate 8. The package substrate 8 is provided with a recess 8' of an inverted frustoconical shape having an increasing diameter from the bottom to the top. LED chip 1 is secured to the bottom of the recess 8' with a die bonding material. Electrodes of LED chip 1 are electrically connected to electrodes 9 on substrate 8 via bonding wires 4.

The recess 8' in substrate 8 is filled and sealed with a resin encapsulant 5 which is obtained by curing the curable composition of the invention.

The LED chip 1 used herein is not particularly limited, and any light-emitting member used in well-known LED chips may be applied. Suitable light-emitting members include those prepared by depositing a semiconductor material on a substrate optionally having a buffer layer of GaN or AlN, by various methods including MOCVD, HDVPE and liquid phase growth methods. The substrate may be made of various materials, for example, sapphire, spinel, SiC, Si, ZnO, and GaN single crystal. Of these, sapphire is preferred because of great industrial utility value in that it facilitates formation of crystalline GaN.

Suitable semiconductor materials to be deposited include GaAs, GaP, GaAlAs, GaAsP, AlGaInP, GaN, InN, AlN, InGaN, InGaAlN, and SiC. Of these, nitride compound semiconductors (InₓGa_{y}Al_{z},N) are preferred for high emission intensity. These materials may be doped with activators.

The light-emitting members include homo-, hetero- and double hetero-junction structures having MIS, pn and PIN junctions. They may also have either a single or a multiple quantum well structure. A passivation layer may or may not be provided in the light-emitting member.

The light-emitting member produces light whose wavelength may vary from UV to IR. Better results are obtained when a light-emitting member provides a main emission peak wavelength of up to 550 nm. A single light-emitting member may be used to produce monochromatic emission while a plurality of light-emitting members may be used to produce monochromatic or polychromatic emission.

The light-emitting member may be provided with electrodes by well-known techniques. Electrodes on the light-emitting member may be electrically connected to leads by various techniques. For electrical connection, connectors capable of establishing good ohmic and mechanical contact with electrodes are preferred. Typical electrical connectors are bonding wires 4 of gold, silver, copper, platinum, aluminum or alloys thereof as shown in FIGS. 1 and 2. Also useful are electroconductive adhesives based on resins loaded with electroconductive fillers such as silver or carbon. Of these, aluminum or gold wires are preferred for efficient working. It is noted that the first and second leadframes 2 and 3 are typically made of copper, copper-zinc alloys or iron-nickel alloys.

The resin enclosure 7 is not particularly limited as long as it is a light transmissive resin. Epoxy and silicone resins are often used.

The package substrate 8 may be made of various materials, for example, polycarbonate resins, polyphenylene sulfide resins, polybutylene terephthalate resins, polyamide resins, liquid crystal polymers, epoxy resins, acrylic resins, silicone resins, ABS resins, BT resins, and ceramics. In the package substrate, a white pigment such as barium titanate, titanium oxide, zinc oxide or barium sulfate is preferably incorporated for imparting an improved light reflectance.

The resin encapsulant 5 in which LED chip 1 is embedded is obtained by curing the curable composition of the invention. The curable composition is defined as comprising (A) a linear polyfluoro compound, (B) a fluorinated organohydrogensiloxane, (C) a platinum group metal catalyst, and (D) a silica powder, which are described below in detail.

### Component A

Component (A) is a linear polyfluoro compound having at least two alkenyl groups in the molecule and a perfluoropolyether structure in the backbone. Preferably, the polyfluoro compound has the general formula (1). 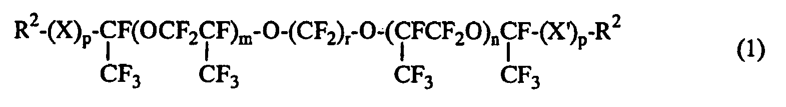 Herein R² is alkenyl, X is a group: -CH₂- , -CH₂O-, -CH₂OCH₂- or -Y-NR¹-CO- wherein Y is -CH₂- or o-, m- or p-silylphenylene of the following structural formula (2): 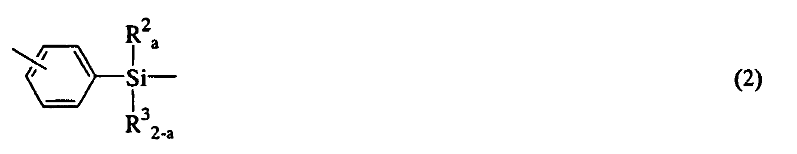 (wherein R² is alkenyl, R³ is hydrogen or a substituted or unsubstituted, monovalent hydrocarbon group which does not contain an aliphatic unsaturated bond, and "a" is 0, 1 or 2) and R¹ is hydrogen or a substituted or unsubstituted, monovalent hydrocarbon group,

X' is a group: -CH₂- , -OCH₂-, -CH₂OCH₂- or -CO-NR¹-Y'- wherein Y' is -CH₂- or o-, m- or p-silylphenylene of the following structural formula (3): 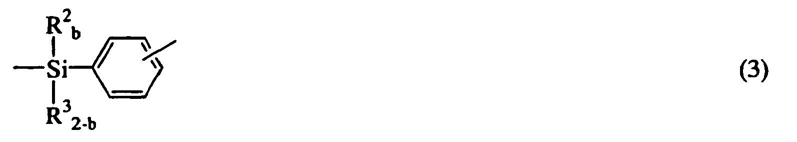 (wherein R² and R³ are as defined above, and "b" is 0, 1 or 2) and R¹ is as defined above,

p is independently 0 or 1, r is an integer of 2 to 6, m and n each are an integer of 1 to 90, the sum of m and n is 2 to 180.

More particularly, R¹ is hydrogen or a substituted or unsubstituted, monovalent hydrocarbon group. Suitable hydrocarbon groups are of 1 to 12 carbon atoms, preferably of 1 to 10 carbon atoms. Examples include alkyl groups such as methyl, ethyl, propyl, butyl, hexyl, cyclohexyl and octyl; aryl groups such as phenyl and tolyl; aralkyl groups such as benzyl and phenylethyl; and substituted forms of the foregoing groups in which some or all hydrogen atoms are substituted by halogen atoms such as fluorine.

R² is alkenyl. Suitable alkenyl groups are of 2 to 8 carbon atoms, preferably 2 to 6 carbon atoms, and they are preferably terminated with CH₂=CH- structure. Examples include vinyl, allyl, propenyl, isopropenyl, butenyl and hexenyl, with vinyl and allyl being most preferred.

R³ is hydrogen or a substituted or unsubstituted, monovalent hydrocarbon group. Suitable hydrocarbon groups are of 1 to 12 carbon atoms, preferably of 1 to 10 carbon atoms. Examples include alkyl groups such as methyl, ethyl, propyl, butyl, hexyl, cyclohexyl and octyl; aryl groups such as phenyl and tolyl; aralkyl groups such as benzyl and phenylethyl; and substituted forms of the foregoing groups in which some or all hydrogen atoms are substituted by halogen atoms such as fluorine. Inter alia, methyl and ethyl are preferred.

Illustrative non-limiting examples of the linear polyfluoro compound having formula (1) are given below. 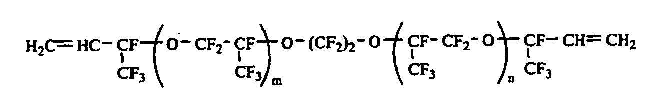 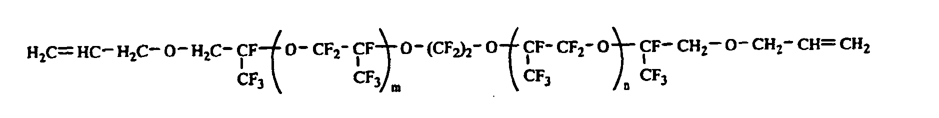 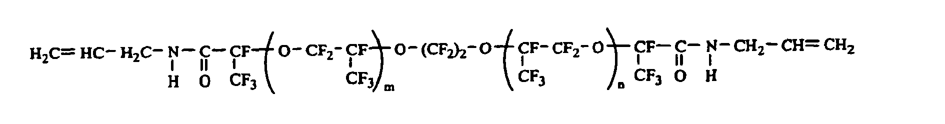 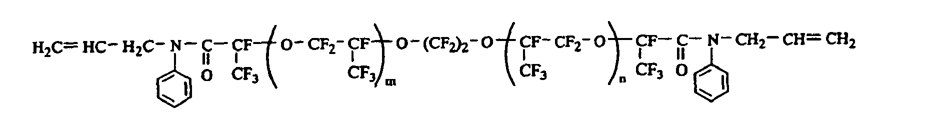 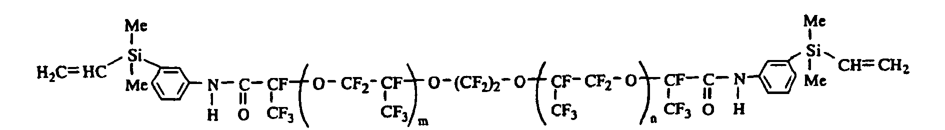 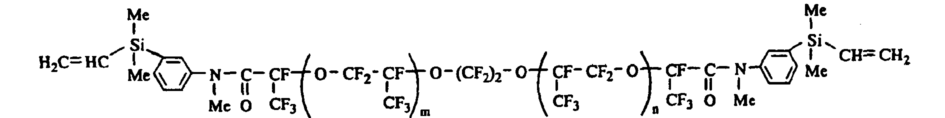 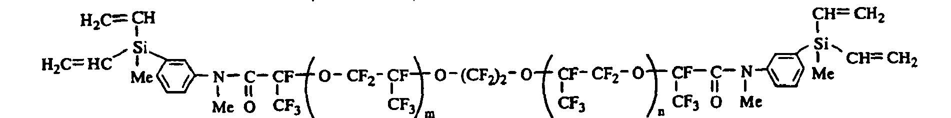 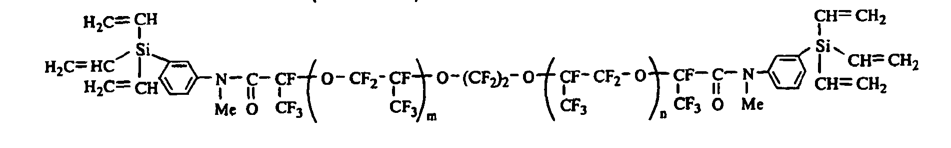 Note that m and n each are an integer of 1 to 90, and the sum of m and n is 2 to 180.

These linear polyfluoro compounds may be used alone or in admixture of two or more.

Preferably the linear polyfluoro compound of formula (1) contains 0.002 to 0.3 mole of alkenyl per 100 g of the compound. An alkenyl content of 0.008 to 0.2 mol/100 g is more preferable. An alkenyl content of less than 0.002 mol/100 g is undesirable because it may lead to an insufficient degree of crosslinking or under-cure. An alkenyl content in excess of 0.3 mol/100 g is undesirable because the composition may cure into a rubber elastomer with poor mechanical properties.

### Component B

Component (B) is a fluorinated organohydrogensiloxane having at least two silicon-bonded hydrogen atoms in the molecule. It serves as a crosslinker or chain extender for component (A). For compatibility with and dispersibility in component (A) and cured uniformity, it is preferred that the organohydrogensiloxane have at least one fluorinated group such as monovalent perfluoroalkyl, monovalent perfluorooxyalkyl, divalent perfluoroalkylene or divalent perfluorooxyalkylene group in the molecule.

Suitable fluorinated groups include those of the following formulae.

C_{g}F₂₉₊₁⁻

-C₉F_{2g}⁻

Herein g is an integer of 1 to 20, and preferably 2 to 10. 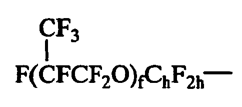 Herein f is an integer of 2 to 200, and preferably 2 to 100, and h is an integer of 1 to 3. 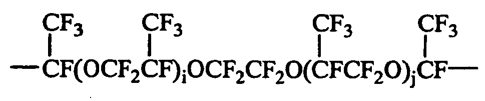 Herein i and j each are an integer of at least 1, and an average of i+j is 2 to 200, and preferably 2 to 100.

-(CF₂O)ᵣ- (CF₂CF₂O)ₛ-CF₂-

Herein r and s each are an integer of 1 to 50.

Examples of a divalent linker that links a perfluoroalkyl, perfluorooxyalkyl, perfluoroalkylene or perfluorooxyalkylene group to a silicon atom include alkylene groups, arylene groups, and combinations thereof, which may be separated by an ether bonding oxygen atom, amide bond or a carbonyl bond. Suitable linkers are of 2 to 12 carbon atoms, and include, but are not limited to, -CH₂CH₂- -CH₂CH₂CH₂-, -CH₂CH₂CH₂OCH₂-, -CH₂CH₂CH₂-NH-CO-, -CH₂CH₂CH₂-N(Ph)-CO-, -CH₂CH₂CH₂-N(CH₃) -CO-, and -CH₂CH₂CH₂-O-CO- .

In addition to the monovalent organic group containing a mono- or divalent fluorinated substituent group, i.e., perfluoroalkyl, perfluorooxyalkyl, perfluoroalkylene or perfluorooxyalkylene group, the fluorinated organohydrogenpolysiloxane (B) may have another monovalent substituent group bonded to a silicon atom. Such other monovalent substituent groups include substituted or unsubstituted, monovalent hydrocarbon groups of 1 to 20 carbon atoms, for example, alkyl groups such as methyl, ethyl, propyl, butyl, hexyl, cyclohexyl, octyl and decyl; alkenyl groups such as vinyl and allyl; aryl groups such as phenyl, tolyl and naphthyl; aralkyl groups such as benzyl and phenylethyl; and substituted forms of the foregoing groups in which at least some hydrogen atoms are substituted by chlorine, cyano or other groups, such as chloromethyl, chloropropyl, and cyanoethyl. Those groups free of aliphatic unsaturation (i.e., groups other than alkenyl) are preferred.

The fluorinated organohydrogenpolysiloxane (B) may have a cyclic, chain or three-dimensional network structure or a combination thereof. The number of silicon atoms is not particularly limited although the organohydrogenpolysiloxane generally has 2 to 200, preferably 3 to 150, and more preferably 3 to 100 silicon atoms.

Included in the fluorinated group-bearing component (B) are those compounds exemplified below which may be used alone or in admixture.

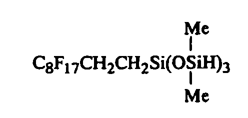

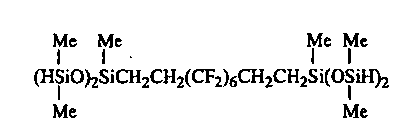

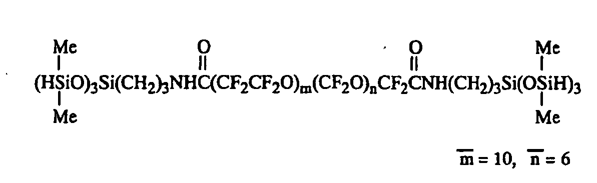

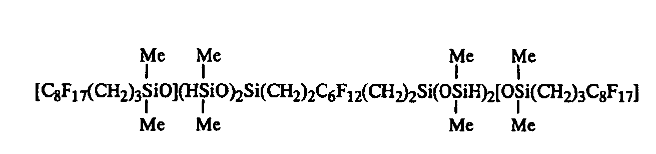

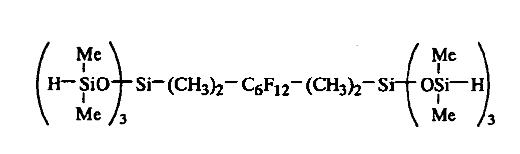

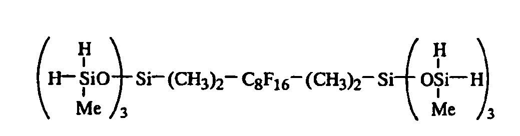

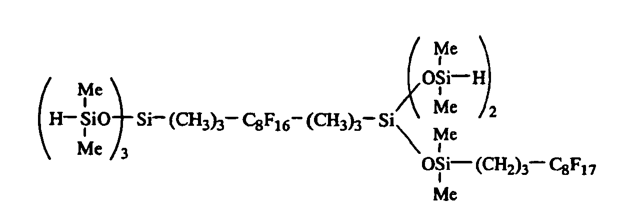

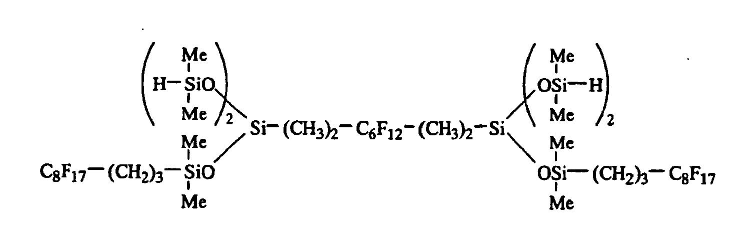

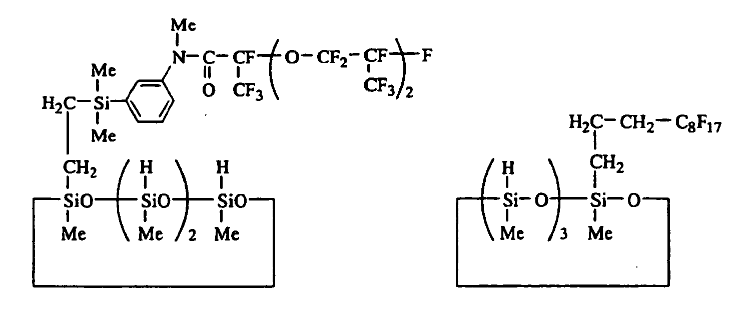

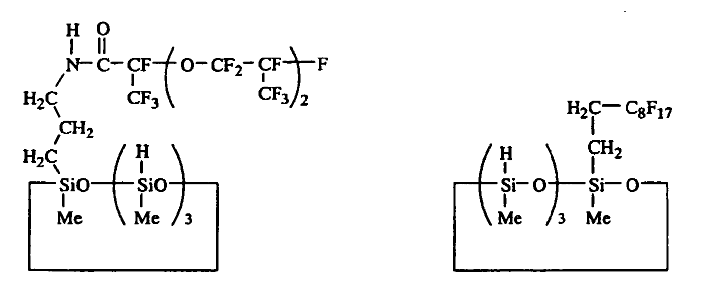

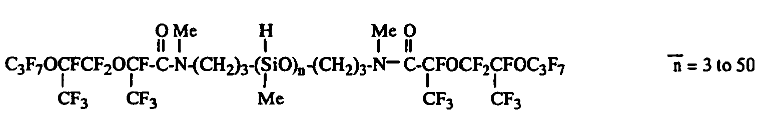

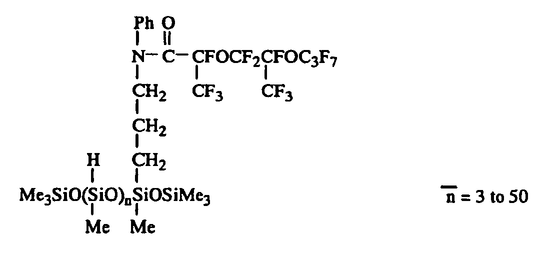

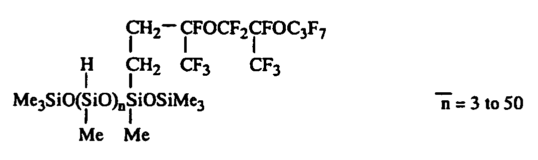

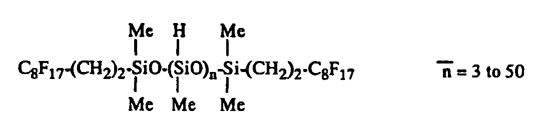

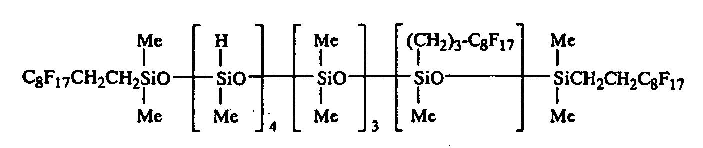

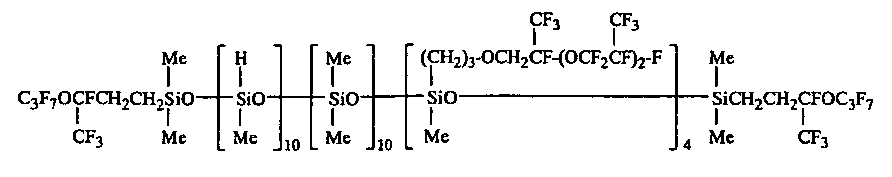

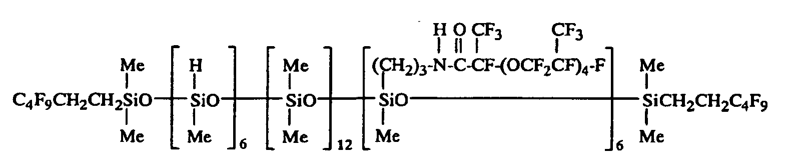

Component (B) may be used in an effective amount to cure component (A), usually in an amount to give 0.5 to 3.0 moles, and preferably 0.8 to 2.0 moles of hydrosilyl (≡SiH) groups per mole of alkenyl groups (e.g., vinyl, allyl and cycloalkenyl) in component (A). With fewer hydrosilyl groups available, the result may be an insufficient degree of crosslinking or cure failure. Too much hydrosilyl groups may cause foaming during the cure step.

### Component C

Component (C) is a platinum group metal catalyst for hydrosilylation reaction. The hydrosilylation catalyst is to promote addition reaction between alkenyl groups in component (A) and hydrosilyl groups in component (B). The hydrosilylation catalysts are generally noble metals and compounds thereof, which are expensive. Of these, platinum and platinum compounds are often used because they are relatively readily available.

Suitable platinum compounds include chloroplatinic acid, complexes of chloroplatinic acid with olefins such as ethylene, complexes of chloroplatinic acid with alcohols and vinylsiloxanes, and metallic platinum on silica, alumina and carbon carriers. Suitable platinum group metal catalysts other than the platinum compounds include rhodium, ruthenium, iridium and palladium compounds, such as, for example, RhCl(PPh₃)₃, RhCl(CO)(PPh₃)₃, Ru₃(CO)₁₂, IrCl(CO) (PPh₃)₂, and Pd(PPh₃)₄.

These catalysts, which are often solid, may be used in the solid form. However, a solution of chloroplatinic acid or complex thereof in a suitable solvent is preferably used because the solution is compatible with the linear polyfluoro compound (A) so that a cured product becomes more uniform.

The hydrosilylation catalyst may be used in a catalytic amount, which may be determined as appropriate depending on the desired cure rate. Usually, the catalyst is used in such an amount as to give 0.1 to 500 ppm of platinum group metal based on the weight of component (A).

### Component D

Component (D) is a silica powder having a specific surface area of 50 to 400 m²/g as measured by the BET method, which is to impart an appropriate physical strength to the cured composition. Component (D) has an additional function of facilitating uniform dispersion of components (F) and (G) in the curable composition. The silica powder as component (D) is finely divided silica having a BET specific surface area of 50 to 400 m²/g, which is well known as the filler for silicone rubber. Known types include fumed silica, precipitated silica, and silica aerogel, with fumed silica being most preferred.

Component (D) should preferably have a BET specific surface area of 50 to 400 m²/g. A silica powder with a surface area of less than 50 m²/g is difficult to achieve the addition effects. A silica powder with a surface area of more than 400 m²/g may cause a viscosity buildup to the curable composition, leading to uneven dispersion of component (D) or difficulty of compounding.

Component (D) may be surface treated with various agents such as organochlorosilanes, organodisilazanes and cyclic organopolysilazanes.

Component (D) is used in an amount of 0.01 to 10 parts, and preferably 0.1 to 5 parts by weight per 100 parts by weight of component (A). With less than 0.01 phr of component (D), the composition may cure into a product with poor physical properties. More than 10 phr of component (D) may have negative impact on the flow of the curable composition and the transparency of the cured composition, which is detrimental to the application of the composition to light-emitting devices.

### Component E

To the curable composition, various additives may be optionally added for enhancing its commercial utility. In particular, an organosilane or organosiloxane may be added as component (E). It is an organosilane or organosiloxane having at least one monovalent perfluoroalkyl, monovalent perfluorooxyalkyl, divalent perfluoroalkylene or divalent perfluorooxyalkylene group and at least one silicon-bonded hydroxyl and/or alkoxy group in the molecule.

Component (E) functions as a surface treating agent for component (D). Component (E) is added when a mixture of component (A) and silica powder (component D) is heat kneaded in a mixing apparatus such as a kneader. When heat treatment is effected optionally with a small amount of water added, surface silanol on silica particles is treated. This treatment improves the miscibility of the silica powder with other components, restraining the composition from a "crepe hardening" phenomenon during shelf storage. Component (E) also has positive impact on the flow of the curable composition and the transparency of the cured composition.

The fluorinated organosilane or organosiloxane (E) has at least one monovalent perfluoroalkyl, monovalent perfluorooxyalkyl, divalent perfluoroalkylene or divalent perfluorooxyalkylene group in the molecule and at least one silicon-bonded hydroxyl and/or alkoxy group in the molecule. Its molecular structure is not particularly limited.

In the fluorinated organosilane or organosiloxane (E), examples of the monovalent organic group containing a mono- or divalent fluorinated substituent group, i.e., perfluoroalkyl, perfluorooxyalkyl, perfluoroalkylene or perfluorooxyalkylene group include the same as those mono- or divalent fluorinated groups illustrated for component (B), and other monovalent substituent groups bonded to a silicon atom include monovalent hydrocarbon groups of 1 to 10 carbon atoms, especially 1 to 8 carbon atoms, free of aliphatic unsaturation.

In the fluorinated organosilane or organosiloxane (E), the number of silicon atoms per molecule is not particularly limited. Usually, the fluorinated organosiloxane has 1 or 2 silicon atoms, and the fluorinated organosiloxane has 2 to 20, preferably 3 to 10 silicon atoms.

These compounds may be prepared by subjecting organic fluorinated compounds having an alkenyl group such as allyl or vinyl and a monovalent perfluoroalkyl, monovalent perfluorooxyalkyl, divalent perfluoroalkylene or divalent perfluorooxyalkylene group to well-known hydrosilylation reaction or hydrolysis reaction.

Examples of the fluorinated organosilane or organosiloxane (E) include the following compounds, which may be used alone or in admixture.

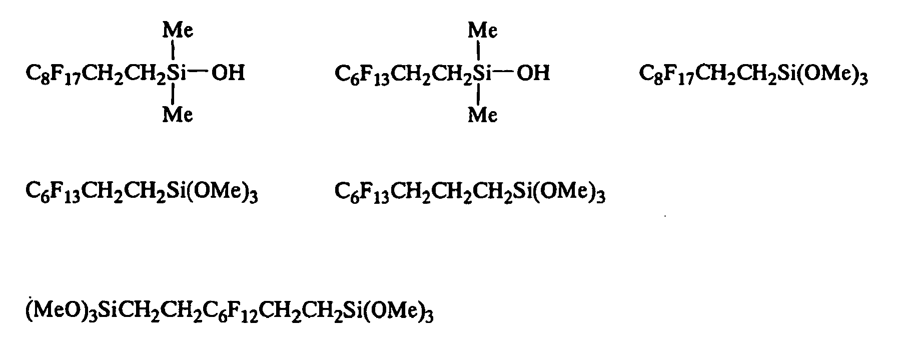

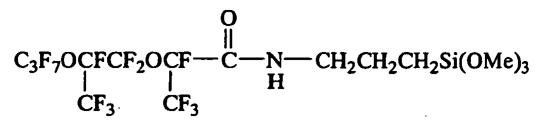

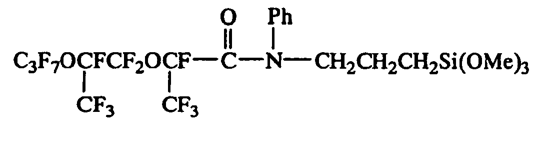

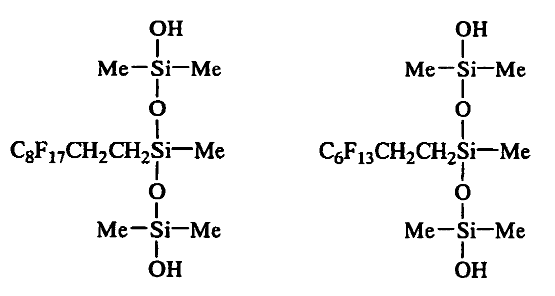

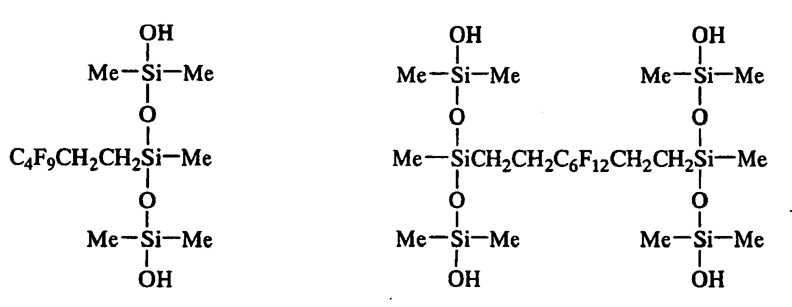

Component (E) is used in an amount of 1 to 30 parts, and preferably 1 to 20 parts by weight per 100 parts by weight of component (D). On this basis, less than 1 part of component (E) may achieve insufficient treatment effects whereas more than 30 parts of component (E) may interfere with curing and result in a cured product having poor physical properties.

### Component F

For the purpose of imparting self-adhesion to the curable composition of the invention, an organosilicon compound having at least one epoxy group and/or at least one silicon-bonded alkoxy group in the molecule is preferably added as component (F).

For compatibility with and dispersibility in component (A) and cured uniformity, it is preferred that the organosilicon compound have at least one monovalent perfluoroalkyl, monovalent perfluorooxyalkyl, divalent perfluoroalkylene or divalent perfluorooxyalkylene group in the molecule like the mono or divalent fluorinated group described and exemplified for component (B).

Illustrative, non-limiting examples of component (F) are given below.

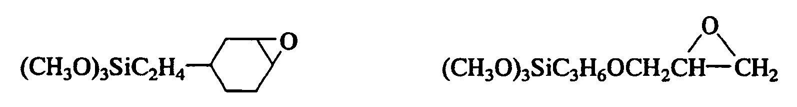

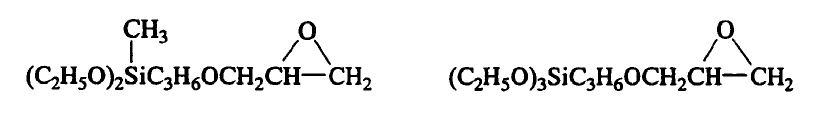

Component (F) is preferably used in an amount of 0.01 to 5.0 parts, and more preferably 0.1 to 3.0 parts by weight per 100 parts by weight of component (A). Less than 0.01 phr of component (F) may fail to achieve satisfactory adhesion whereas more than 5.0 phr may interfere with the flow of the curable composition and have a negative impact on the physical strength of the cured composition.

### Component G

Whether or not component (F) is added, an organosiloxane is desirably added as component (G) for the same purpose as component (F). Component (G) is an organosiloxane having in the molecule at least one silicon-bonded hydrogen atom and at least one epoxy group and/or trialkoxysilyl group bonded to a silicon atom via carbon atoms or carbon and oxygen atoms.

For compatibility with and dispersibility in component (A) and cured uniformity, it is preferred that the organosiloxane (G) have at least one monovalent perfluoroalkyl or perfluorooxyalkyl group bonded to a silicon atom via carbon atoms or carbon and oxygen atoms.

The organosiloxane (G) has a siloxane structure which may be cyclic, chain-like or branched or a mixture thereof. Suitable examples of the organosiloxane (G) are shown below. 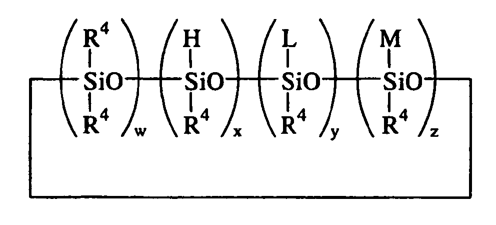 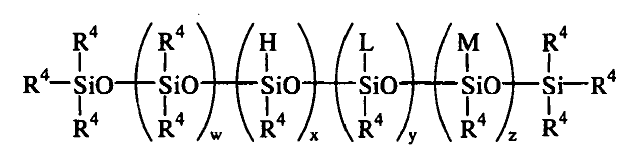 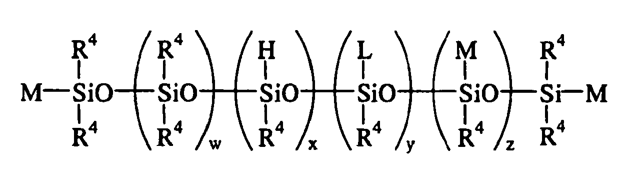 Herein R⁴ is a halo-substituted or unsubstituted monovalent hydrocarbon group, L and M will be defined below, w is an integer of 0 to 50, preferably 0 to 20, x is an integer of 1 to 50, preferably 1 to 20, y is an integer of 1 to 50, preferably 1 to 20, z is an integer of 0 to 50, preferably 0 to 20, and w+x+y+z is such an integer that the compound has a weight average molecular weight of 2,000 to 20,000 as determined by GPC versus polystyrene standards.

Suitable halo-substituted or unsubstituted monovalent hydrocarbon groups represented by R⁴ are of 1 to 10 carbon atoms, preferably 1 to 8 carbon atoms, and include alkyl groups such as methyl, ethyl, propyl, butyl, hexyl, cyclohexyl and octyl; aryl groups such as phenyl and tolyl; aralkyl groups such as benzyl and phenylethyl; and substituted forms of the foregoing groups in which some or all hydrogen atoms are substituted by halogen atoms such as fluorine. Inter alia, methyl is most preferred.

L is an epoxy group and/or trialkoxysilyl group bonded to a silicon atom via carbon atoms or carbon and oxygen atoms, which is exemplified by groups of the following formulae. 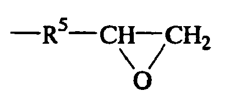 Herein R⁵ is a divalent hydrocarbon group of 1 to 10 carbon atoms, more specifically 1 to 5 carbon atoms, which may be separated by an oxygen atom, for example, alkylene such as methylene, ethylene, propylene, butylene, hexylene, cyclohexylene or octylene.

-R⁶-Si (OR⁷)₃

Herein R⁶ is a divalent hydrocarbon group of 1 to 10 carbon atoms, more specifically 1 to 4 carbon atoms, for example, alkylene such as methylene, ethylene, propylene, butylene, hexylene, cyclohexylene or octylene, and R⁷ is a monovalent hydrocarbon group of 1 to 8 carbon atoms, more specifically 1 to 4 carbon atoms, for example, alkyl such as methyl, ethyl or n-propyl. 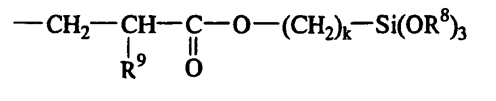 Herein R⁸ is a monovalent hydrocarbon group of 1 to 8 carbon atoms, more specifically 1 to 4 carbon atoms, for example, alkyl, R⁹ is hydrogen or methyl, and k is an integer of 2 to 10.

M preferably denotes a structure of the general formula (4).

-Z-Rf (4)

In formula (4), Z is preferably -(CH₂)ₜ-X"-. X" is a group: -OCH₂- or -Y"-NR¹⁰-CO- wherein Y" is -CH₂- or o, m or p-silylphenylene of the structural formula (5): 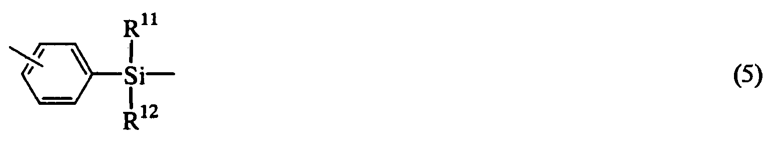 wherein R¹¹ and R¹² each are hydrogen, a substituted or unsubstituted, monovalent saturated hydrocarbon group, or a substituted or unsubstituted, monovalent unsaturated hydrocarbon group, R¹⁰ is hydrogen or a substituted or unsubstituted, monovalent hydrocarbon group, preferably of 1 to 12 carbon atoms, more preferably of 1 to 10 carbon atoms, and t is an integer of 1 to 10, preferably 1 to 5.

Rf is a monovalent perfluoroalkyl or perfluorooxyalkyl group. Exemplary monovalent perfluoroalkyl or perfluorooxyalkyl groups are the same as exemplified as the monovalent fluorinated group in component (B) and include those of the following general formulae.

C_{g}F_{2g+1} -

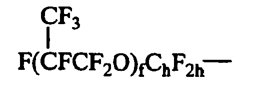

Herein g is an integer of 1 to 20, and preferably 2 to 10, f is an integer of 2 to 200, and preferably 2 to 100, and h is an integer of 1 to 3.

These organosiloxanes may be obtained by combining an organohydrogenpolysiloxane having at least three silicon-bonded hydrogen atoms (SiH groups) in the molecule with a compound having an aliphatic unsaturated group (e.g., vinyl or allyl) and an epoxy and/or trialkoxysilyl group and optionally, a compound having an aliphatic unsaturated group and a perfluoroalkyl or perfluorooxyalkyl group and effecting partial addition reaction therebetween in accordance with a standard procedure. The amounts of the reactants combined should be such that the number of aliphatic unsaturated groups be smaller than the number of SiH groups.

In the preparation of the organosiloxane (G), the end compound may be isolated from the reaction mixture at the end of reaction although the reaction mixture may be used as long as the unreacted reactants and addition reaction catalyst have been removed therefrom.

Suitable organosiloxanes which can serve as component (G) include those of the following structural formulae, which may be used alone or in admixture. 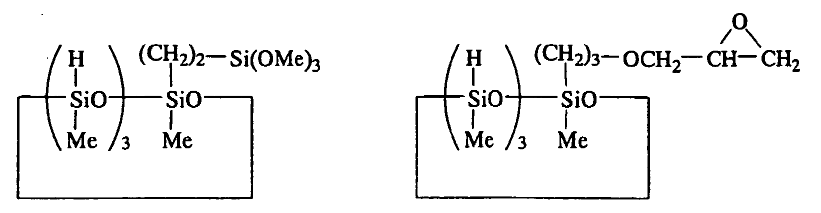 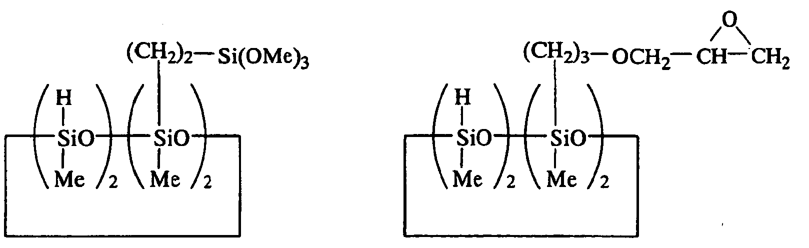 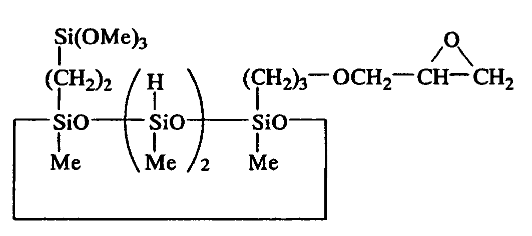 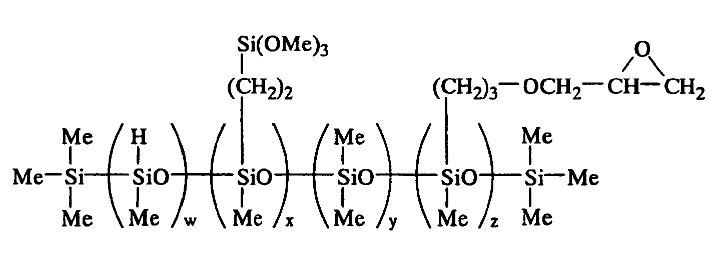 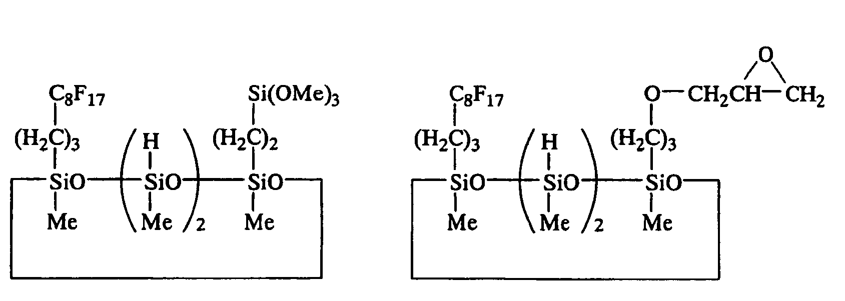 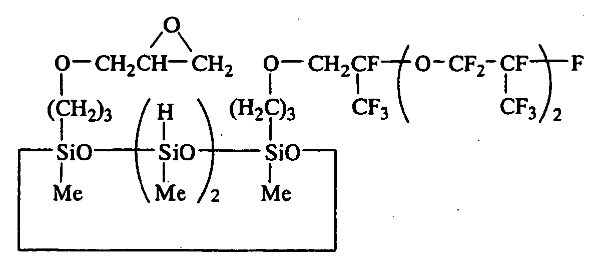 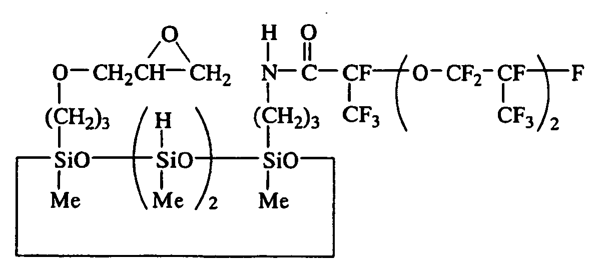 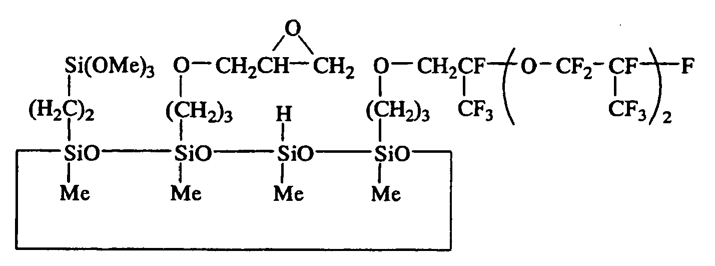 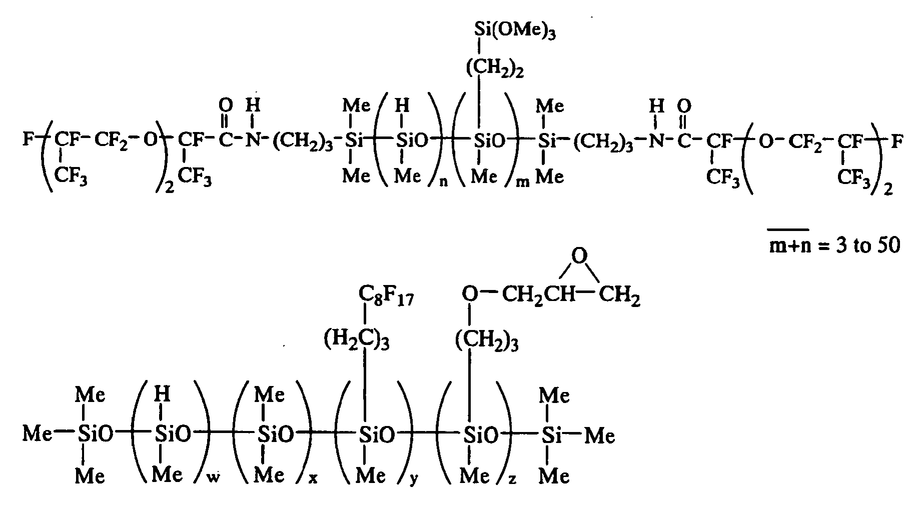 The subscripts w, x, and z are positive integers, and y is an integer inclusive of 0.

Component (G) is preferably used in an amount of 0.1 to 10 parts, and more preferably 0.5 to 5.0 parts by weight per 100 parts by weight of component (A). Less than 0.1 phr of component (G) may fail to achieve satisfactory adhesion whereas more than 10 phr may interfere with the flow of the curable composition and have a negative impact on the physical strength of the cured composition.

The light-emitting device is fabricated by encapsulating a LED chip with the composition of the invention in the cured state. Sometimes the cured composition should be bonded to the package substrate. In such cases, various primers may be applied instead of adding component (F) and/or (G) to the composition. Alternatively, various primers may be applied while component (F) and/or (G) is added to the composition.

### Other components

In addition of the aforementioned components (A) to (G), various additives such as a plasticizer, viscosity modifier, flexibilizer, inorganic filler and tackifier may be added to the curable composition for enhancing its commercial utility. Such additives are compounded in any desired amounts as long as they do not compromise the objects of the invention or adversely affect the properties of the curable composition and the physical properties of the cured composition.

As the plasticizer, viscosity modifier or flexibilizer, a polyfluoromonoalkenyl compound having the general formula (6) and/or linear polyfluoro compounds having the general formulae (7) and (8) may be used.

Rf³-(X')ₚCH=CH₂ (6)

Herein X' and p are as defined in formula (1), and Rf³ is a group of the general formula (9): 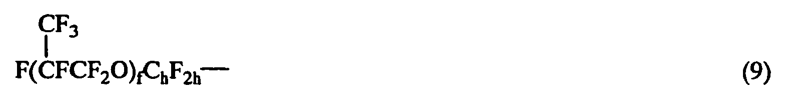 wherein h is 2 or 3 and f is an integer of at least 1 and smaller than the sum of m+n (average) and r in conjunction with component (A).

D-O-(CF₂CF₂CF₂O)_{c}-D (7)

Herein D is a group: CₛF₂ₛ₊₁ - wherein s is 1 to 3, and c is an integer of 1 to 200 and smaller than the sum of m+n (average) and r in conjunction with component (A).

D-O- (CF₂O)_{d}(CF₂CF₂O)ₑ-D (8)

Herein D is as defined above, d and e each are an integer of 1 to 200 and the sum of d and e is not more than the sum of m+n (average) and r in conjunction with component (A).

Examples of the polyfluoromonoalkenyl compound of formula (6) are given below.

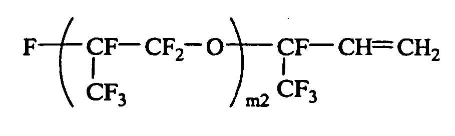

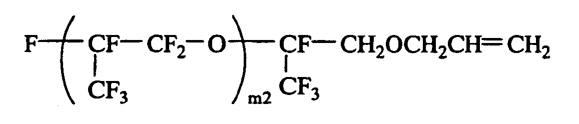

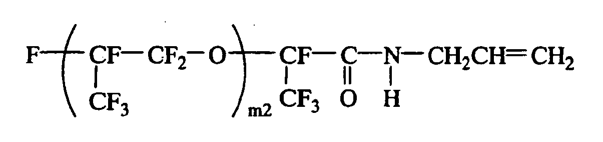

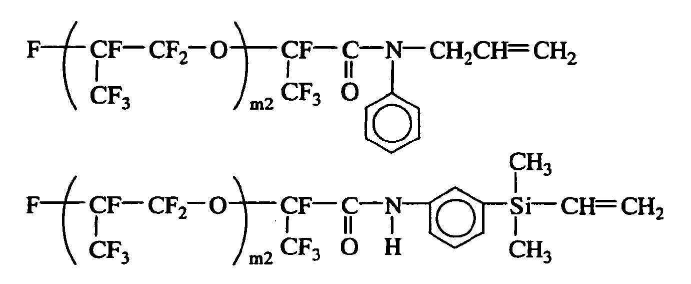

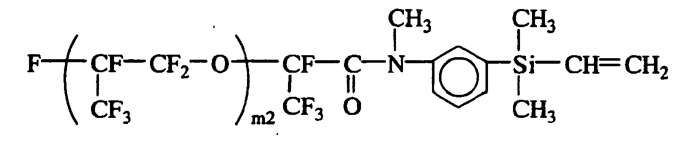

Note that m2 is a number satisfying the above requirement.

Examples of the linear polyfluoro compounds having the general formulae (7) and (8) are given below.

CF₃O- (CF₂CF₂CF₂O)ₙ₃-CF₂CF₃

CF₃-[(OCF₂CF₂)ₙ₃ (OCF₂)m₃]-O- CF₃

Note that n3 is an integer of 1 to 200, m3 is an integer of 1 to 200, and m3+n3 is 2 to 201.

As the tackifier, carboxylic anhydrides or titanates may be added.

Moreover, hydrosilylation catalyst regulators may be added which include acetylenic alcohols such as 1-ethynyl-1-hydroxycyclohexane, 3-methyl-1-butyn-3-ol, 3,5-dimethyl-1-hexyn-3-ol, 3-methyl-1-penten-3-ol, and phenylbutynol, the reaction product of a chlorosilane having a monovalent fluorinated substituent group (as described above) and an acetylenic alcohol, 3-methyl-3-penten-1-yn, 3,5-dimethyl-3-hexen-1-yn, triallyl isocyanurate, polyvinyl siloxane, and organophosphorus compounds.

To the curable composition, a phosphor may be added for controlling the wavelength of light emerging out of the device. Suitable phosphors include Ce-doped YAG phosphors, specifically cerium-doped garnet phosphors containing at least one element selected from Y, Lu, Sc, La, Gd and Sm and at least one element selected from Al, Ga and In).

### Preparation of curable composition

The method of preparing the curable composition is not particularly limited. For example, it may be prepared by mixing components (A) to (G) and optional components on a mixing device (e.g., planetary mixer, Ross mixer, Hobart mixer) or a kneading device (e.g., kneader, three-roll mill). Because effective surface treatment of silica powder (D) with fluorinated organosilane or organosiloxane (E) is accomplished, the composition is preferably prepared by providing a mixture of linear polyfluoro compound (A) and silica powder (D), adding fluorinated organosilane or organosiloxane (E) to the mixture, heat treating the resulting mixture on a kneading device such as a kneader, adding the remaining components to the mixture, and mixing the contents until uniform.

With respect to the formulation of the curable composition, the composition may be formulated as one part wherein all components (A) to (E) and optional other components are combined and handled as a single compound. Alternatively, the composition may be formulated as two parts which are mixed on use.

The curable composition may be cured at a temperature of 20 to 200°C, and preferably 50 to 180°C, although the curing conditions are not limited thereto. An appropriate curing time may be determined such that crosslinking reaction and bonding reaction to the package substrate in the light-emitting device are complete within that time. Usually the curing time is 10 minutes to 10 hours, and preferably 30 minutes to 8 hours.

Prior to use, the curable composition may be dissolved in a suitable fluorochemical solvent such as 1,3-bis(trifluoromethyl)benzene, Fluorinert® (3M), perfluorobutyl methyl ether or perfluorobutyl ethyl ether in a suitable concentration, if necessary.

Since the cured composition has excellent properties including heat resistance, oil resistance, chemical resistance, solvent resistance and low moisture permeability, it serves as a useful encapsulant in a light-emitting device of molded LED for protecting the LED from corrosive gases such as gaseous sulfur compounds, nitrogen oxides, COx and chlorides.

### EXAMPLE

Examples of the invention are given below by way of illustration and not by way of limitation. All parts are by weight.

### Preparation Example 1

A kneader was charged with 100 parts of a polymer of formula (10) (vinyl content: 0.031 mol/100 g, kinematic viscosity: 2200 mm²/s), to which 60 parts of fumed silica surface treated with dimethyldichlorosilane and having a BET surface area of 110 m²/g and 4.5 parts of a fluorinated organosiloxane of formula (11) were added. With kneading, the contents were heated to 170°C and heat treated for 3 hours. Then 200 parts of the polymer of formula (10) was added to the mixture, which was mixed until uniform. The contents were cooled below 40°C and worked on a three-roll mill in two passes, obtaining a base compound. To 6.1 parts of the base compound, 95 parts of the polymer of formula (10) was added and mixed. To this mixture, 0.8 part of a fluorinated ethynyl cyclohexanol of formula (12), 0.3 part of a toluene solution of platinum/divinyltetramethyldisiloxane complex (Pt concentration 0.5 wt%), 5.4 parts of a fluorinated organohydrogensiloxane of formula (13), 1.4 parts of a fluorinated organohydrogensiloxane of formula (14), and 0.20 part of an organosilicon compound of formula (15) were added in sequence. The contents were mixed until uniform and then deaerated, yielding a composition #1.

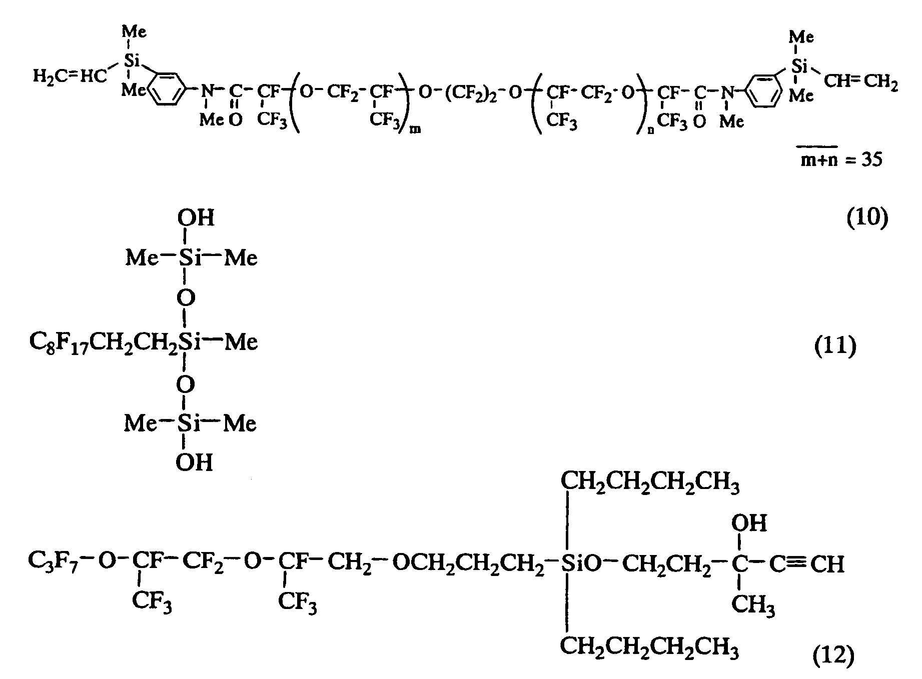

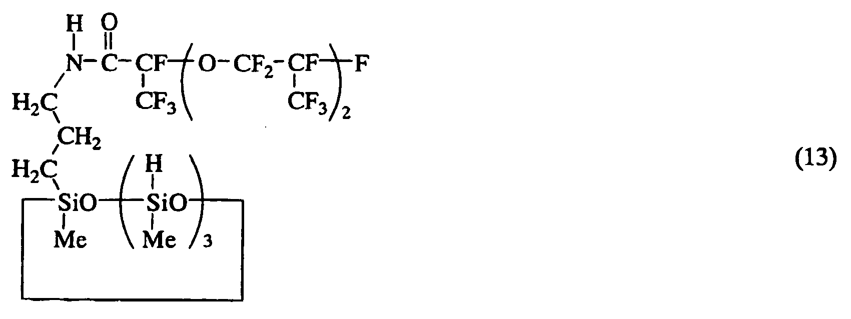

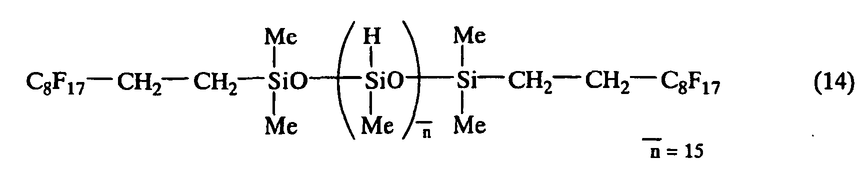

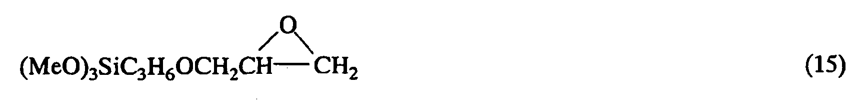

### Preparation Example 2

A composition #2 was prepared as in Preparation Example 1 except that 0.4 part of an organosiloxane of formula (16) was used instead of the organosilicon compound of formula (15).

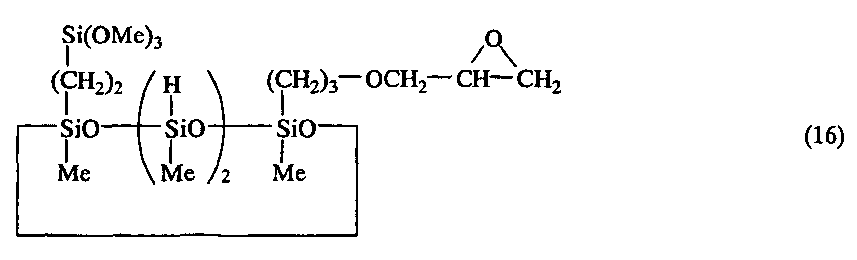

### Preparation Example 3

A composition #3 was prepared as in Preparation Example 1 except that 2.0 part of fluorinated organohydrogensiloxane of formula (17) was used instead of the organosilicon compound of formula (15).

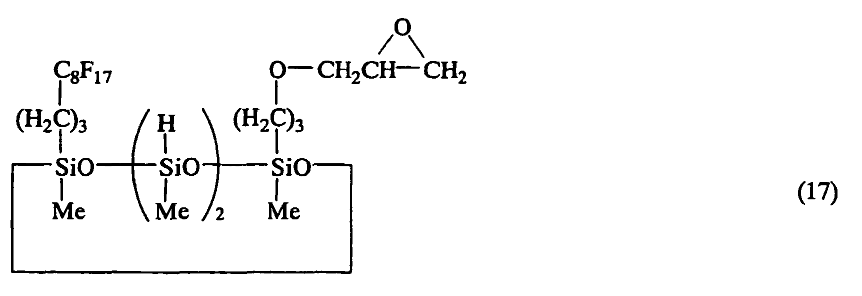

### Example 1

Example 1 demonstrates a light-emitting device of the structure shown in FIG. 2. Specifically, composition #1 was cast into recess 8', heated at 90°C for 2 hours and then at 150°C for 1 hour. In this way, a LED chip 1 capable of blue emission (470 nm) with bonding wires 4 was encapsulated with a resin encapsulant 5 resulting from curing of composition #1, constructing a light-emitting device.

The light-emitting device was operated at the rated value, and a total luminous flux at the initial was measured. Then the device was held for one week in an atmosphere of 5% hydrogen sulfide or 5% NOx (mixture of NO, NO₂ and N₂O), after which it was operated again under the same condition and a total luminous flux was measured. In either atmosphere, the total luminous flux remained equivalent to the initial.

### Example 2

A light-emitting device was constructed as in Example 1 aside from using composition #2 instead of composition #1. As in Example 1, the total luminous flux was compared before and after exposure to hydrogen sulfide and NOx atmospheres. In either atmosphere, the total luminous flux remained equivalent to the initial.

### Example 3

A light-emitting device was constructed as in Example 1 aside from using composition #3 instead of composition #1. As in Example 1, the total luminous flux was compared before and after exposure to hydrogen sulfide and NOx atmospheres. In either atmosphere, the total luminous flux remained equivalent to the initial.

In respect of numerical ranges disclosed herein it will of course be understood that in the normal way the technical criterion for the upper limit is different from the technical criterion for the lower limit, i.e. the upper and lower limits are intrinsically distinct proposals.

## Claims

1. A light-emitting device comprising a light-emitting diode embedded in a resin encapsulant, the resin encapsulant being a cured product of a curable composition comprising
(A) 100 parts by weight of a linear polyfluoro compound having at least two alkenyl groups in the molecule and a perfluoropolyether structure in the backbone,
(B) a fluorinated organohydrogensiloxane having at least two silicon-bonded hydrogen atoms in the molecule in an amount to give 0.5 to 3.0 moles of SiH groups per mole of alkenyl groups in component (A),
(C) 0.1 to 500 ppm calculated as platinum group metal of a platinum group metal catalyst, and
(D) 0.01 to 10 parts by weight of a silica powder having a specific surface area of 50 to 400 m²/g as measured by the BET method.

2. The light-emitting device of claim 1 wherein said curable composition further comprises (E) an organosilane or organosiloxane having at least one monovalent perfluoroalkyl, monovalent perfluorooxyalkyl, divalent perfluoroalkylene or divalent perfluorooxyalkylene group and at least one silicon-bonded hydroxyl and/or alkoxy group in the molecule, in an amount of 1 to 30 parts by weight per 100 parts by weight of the silica powder (D).

3. The light-emitting device of claim 1 or 2 wherein said curable composition further comprises (F) 0.01 to 5.0 parts by weight of an organosilicon compound having at least one epoxy group and/or silicon-bonded alkoxy group in the molecule.

4. The light-emitting device of claim 3 wherein the organosilicon compound (F) has at least one monovalent perfluoroalkyl, monovalent perfluorooxyalkyl, divalent perfluoroalkylene group or divalent perfluorooxyalkylene in the molecule.

5. The light-emitting device of any one of claims 1 to 4 wherein said curable composition further comprises (G) 0.1 to 10 parts by weight of an organosiloxane having in the molecule at least one silicon-bonded hydrogen atom and at least one epoxy group and/or trialkoxysilyl group bonded to a silicon atom via carbon atoms or carbon and oxygen atoms.

6. The light-emitting device of claim 5 wherein the organosiloxane (G) has at least one monovalent perfluoroalkyl or perfluorooxyalkyl group bonded to a silicon atom via carbon atoms or carbon and oxygen atoms.

7. The light-emitting device of any one of claims 1 to 6 wherein the linear polyfluoro compound (A) contains 0.002 to 0.3 mol/100 g of alkenyl.

8. The light-emitting device of any one of claims 1 to 7 wherein component (A) is a linear polyfluoro compound having the general formula (1): 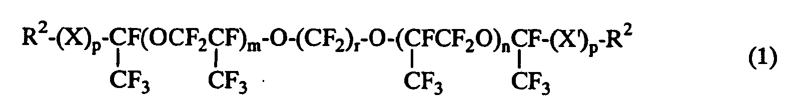
wherein X is a group: -CH₂-, -CH₂O-, -CH₂OCH₂- or -Y-NR¹-CO- wherein Y is -CH₂- or o-, m- or p-silylphenylene of the following structural formula (2): 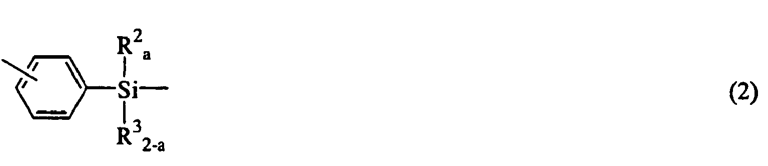 (wherein R² is alkenyl, R³ is hydrogen or a substituted or unsubstituted, monovalent hydrocarbon group which does not contain an aliphatic unsaturated bond, and "a" is 0, 1 or 2) and R¹ is hydrogen or a substituted or unsubstituted, monovalent hydrocarbon group,
X' is a group: -CH₂- , -OCH₂- , -CH₂OCH₂- or -CO-NR¹-Y'- wherein Y' is -CH₂- or o-, m- or p-silylphenylene of the following structural formula (3): 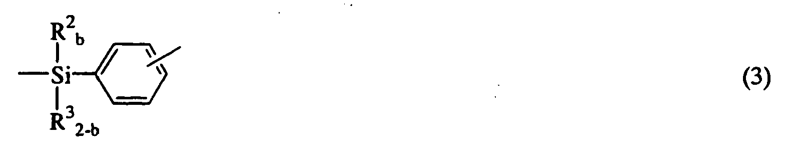 (wherein R² and R³ are as defined above, and "b" is 0, 1 or 2) and R¹ is as defined above,
p is independently 0 or 1, r is an integer of 2 to 6, m and n each are an integer of 1 to 90, the sum of m and n is 2 to 180.

9. The light-emitting device of any one of claims 1 to 8 wherein the fluorinated organohydrogensiloxane (B) has at least one monovalent perfluoroalkyl, monovalent perfluorooxyalkyl, divalent perfluoroalkylene or divalent perfluorooxyalkylene group in the molecule.

10. The use of a curable composition as defined in any one of claims 1 to 9 for encapsulating a light-emitting diode of a light-emitting device.

## Patentansprüche

1. Licht emittierende Vorrichtung, die eine Leuchtdiode in ein Einbettharz eingebettet umfasst, wobei das Einbettharz ein gehärtetes Produkt aus einer härtbaren Zusammensetzung ist, die Folgendes umfasst:
(A) 100 Gewichtsteile einer unverzweigten Polyfluorverbindung mit zumindest zwei Alkenylgruppen pro Molekül und einer Perfluorpolyetherstruktur im Rückgrat,
(B) ein fluoriertes Organohydrogensiloxan mit zumindest zwei siliciumgebundenen Wasserstoffatomen pro Molekül in einer Menge, die 0,5 bis 3,0 mol SiH-Gruppen pro Mol Alkenylgruppen in Komponente (A) ergibt,
(C) 0,1 bis 500 ppm, berechnet als Platingruppenmetall, eines Platingruppenmetallkatalysators und
(D) 0,01 bis 10 Gewichtsteile eines Silicapulvers mit einer nach dem BET-Verfahren gemessenen spezifischen Oberfläche von 50 bis 400 m²/g.

2. Licht emittierende Vorrichtung nach Anspruch 1, wobei die härtbare Zusammensetzung weiters (E) ein Organosilan oder Organosiloxan mit zumindest einer einwertigen Perfluoralkyl-, einwertigen Perfluoroxyalkyl-, zweiwertigen Perfluoralkylen- oder zweiwertigen Perfluoroxyalkylengruppe und zumindest einer siliciumgebundenen Hydroxy- und/oder Alkoxygruppe pro Molekül in einer Menge von 1 bis 30 Gewichtsteilen pro 100 Gewichtsteile des Silicapulvers (D) umfasst.

3. Licht emittierende Vorrichtung nach Anspruch 1 oder 2, wobei die härtbare Zusammensetzung weiters (F) 0,01 bis 5,0 Gewichtsteile einer Organosiliciumverbindung mit zumindest einer Epoxygruppe und/oder siliciumgebundenen Alkoxygruppe pro Molekül umfasst.

4. Licht emittierende Vorrichtung nach Anspruch 3, wobei die Organosiliciumverbindung (F) zumindest eine einwertige Perfluoralkyl-, einwertige Perfluoroxyalkyl, zweiwertige Perfluoralkylengruppe oder zweiwertige Perfluoroxyalkylengruppe pro Molekül umfasst.

5. Licht emittierende Vorrichtung nach einem der Ansprüche 1 bis 4, wobei die härtbare Zusammensetzung weiters (G) 0,1 bis 10 Gewichtsteile eines Organosiloxans umfasst, das pro Molekül zumindest ein siliciumgebundenes Wasserstoffatom und zumindest eine Epoxygruppe und/oder Trialkoxysilylgruppe über Kohlenstoffatome oder Kohlenstoff- und Sauerstoffatome an ein Siliciumatom gebunden umfasst.

6. Licht emittierende Vorrichtung nach Anspruch 5, wobei das Organosiloxan (G) zumindest eine einwertige Perfluoralkyl- oder Perfluoroxyalkylgruppe über Kohlenstoffatome oder Kohlenstoff- und Sauerstoffatome an ein Siliciumatom gebunden umfasst.

7. Licht emittierende Vorrichtung nach einem der Ansprüche 1 bis 6, wobei die unverzweigte Polyfluorverbindung (A) 0,002 bis 0,3 mol/100 g Alkenyl enthält.

8. Licht emittierende Vorrichtung nach einem der Ansprüche 1 bis 7, wobei Komponente (A) eine unverzweigte Polyfluorverbindung der allgemeinen Formel (1) ist: 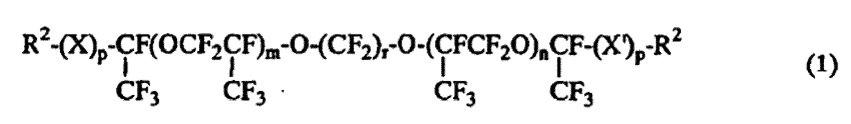
worin X eine Gruppe -CH₂-, -CH₂O-, CH₂OCH₂- oder -Y-NR¹-CO- ist, worin Y -CH₂- oder o-, m- oder p-Silylphenylen der folgenden Strukturformel (2) ist: 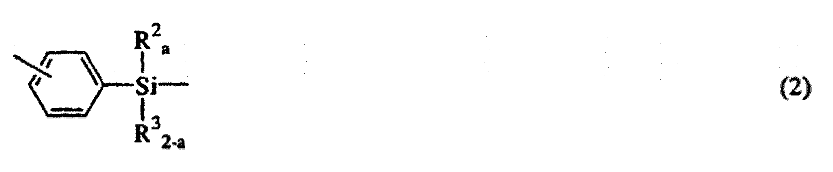 (worin R² Alkenyl ist, R³ Wasserstoff oder eine substituierte oder unsubstituierte, einwertige Kohlenwasserstoffgruppe ist, die keine aliphatische ungesättigte Bindung enthält, und "a" = 0, 1 oder 2 ist) und R¹ Wasserstoff oder eine substituierte oder unsubstituierte, einwertige Kohlenwasserstoffgruppe ist,
X' eine Gruppe -CH₂-, -OCH₂-, CH₂OCH₂- oder -CO-NR¹-Y'- ist, worin Y' -CH₂- oder o-, m- oder p-Silylphenylen der folgenden Strukturformel (3) ist: 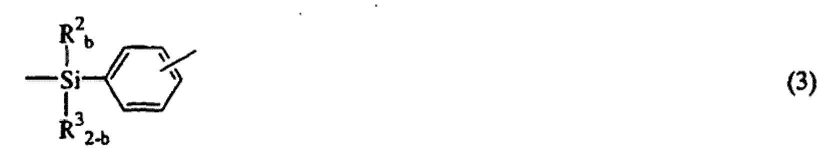 (worin R² und R³ wie oben definiert sind und "b" = 0, 1 oder 2 ist) und R¹ wie oben definiert ist,
p jeweils unabhängig 0 oder 1 ist, r eine ganze Zahl von 2 bis 6 ist und m und n jeweils eine ganze Zahl von 1 bis 90 sind, wobei die Summe aus m und n = 2 bis 180 beträgt.

9. Licht emittierende Vorrichtung nach einem der Ansprüche 1 bis 8, wobei das fluorierte Organohydrogensiloxan (B) zumindest eine einwertige Perfluoralkyl-, einwertige Perfluoroxyalkyl-, zweiwertige Perfluoralkylen- oder zweiwertige Perfluoroxyalkylengruppe pro Molekül aufweist.

10. Verwendung einer härtbaren Zusammensetzung wie in einem der Ansprüche 1 bis 9 definiert zum Einkapseln einer Leuchtdiode einer Licht emittierenden Vorrichtung.

## Revendications

1. Dispositif électroluminescent comprenant une diode électroluminescente encastrée dans une résine d'encapsulation, la résine d'encapsulation étant un produit durci d'une composition durcissable comprenant
(A) 100 parties en poids d'un composé polyfluoré linéaire ayant au moins deux groupes alcényle par molécule et une structure de perfluoropolyéther dans la charpente,
(B) un organohydrogénosiloxane fluoré ayant au moins deux atomes d'hydrogène liés au silicium par molécule en une quantité donnant 0,5 à 3,0 moles de groupes SiH par mole de groupes alcényle dans le composant (A),
(C) 0,1 à 500 ppm, calculées en métal du groupe du platine, d'un catalyseur à base de métal du groupe du platine, et
(D) 0,01 à 10 parties en poids d'une poudre de silice ayant une surface spécifique de 50 à 400 m²/g telle que mesurée par la méthode BET.

2. Dispositif électroluminescent selon la revendication 1, dans lequel ladite composition durcissable comprend en outre (E) un organosilane ou organosiloxane ayant au moins un groupe perfluoroalkyle monovalent, perfluorooxyalkyle monovalent, perfluoroalkylène divalent ou perfluorooxyalkylène divalent et au moins un groupe hydroxyle et/ou alcoxy lié au silicium par molécule, en une quantité de 1 à 30 parties en poids pour 100 parties en poids de la poudre de silice (D).

3. Dispositif électroluminescent selon la revendication 1 ou 2, dans lequel ladite composition durcissable comprend en outre (F) 0,01 à 5,0 parties en poids d'un composé organique du silicium ayant au moins un groupe époxy et/ou un groupe alcoxy lié au silicium par molécule.

4. Dispositif électroluminescent selon la revendication 3, dans lequel le composé organique du silicium (F) a au moins un groupe perfluoroalkyle monovalent, perfluorooxyalkyle monovalent, perfluoro-alkylène divalent ou perfluorooxyalkylène divalent par molécule.

5. Dispositif électroluminescent selon l'une quelconque des revendications 1 à 4, dans lequel ladite composition durcissable comprend en outre (G) 0,1 à 10 parties en poids d'un organosiloxane ayant, par molécule, au moins un atome d'hydrogène lié au silicium et au moins un groupe époxy et/ou un groupe trialcoxysilyle lié à un atome de silicium via des atomes de carbone ou des atomes de carbone et d'oxygène.

6. Dispositif électroluminescent selon la revendication 5, dans lequel l'organosiloxane (G) a au moins un groupe perfluoroalkyle ou perfluorooxyalkyle monovalent lié à un atome de silicium via des atomes de carbone ou des atomes de carbone et d'oxygène.

7. Dispositif électroluminescent selon l'une quelconque des revendications 1 à 6, dans lequel le composé polyfluoré linéaire (A) contient 0,002 à 0,3 mole/100 g d'alcényle.

8. Dispositif électroluminescent selon l'une quelconque des revendications 1 à 7, dans lequel le composant (A) est un composé polyfluoré linéaire de formule générale (1) : 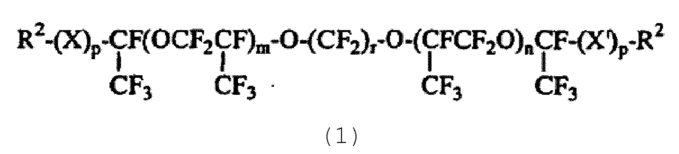 dans laquelle
X est un groupe -CH₂-, -CH₂O-, -CH₂OCH₂- ou -Y-NR¹-CO- où Y est -CH₂- ou un o-, m- ou p-silylphénylène de formule structurelle (2) suivante : 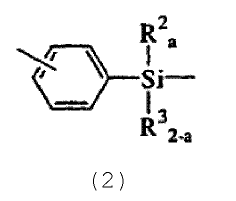 (dans laquelle R² est un alcényle, R³ est l'hydrogène ou un groupe hydrocarboné monovalent substitué ou non substitué ne contenant pas de liaison insaturée aliphatique, et "a" vaut 0, 1 ou 2) et R¹ est l'hydrogène ou un groupe hydrocarboné monovalent substitué ou non substitué,
X' est un groupe -CH₂-, -OCH₂-, -CH₂OCH₂- ou -CO-NR¹-Y' - où Y' est -CH₂- ou un o-, m- ou p-silylphénylène de formule structurelle (3) suivants : 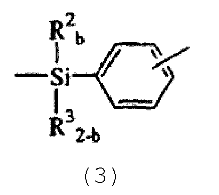 (dans laquelle R² et R³ sont tels que définis ci-dessus, et "b" vaut 0, 1 ou 2) et R¹ est tel que défini ci-dessus,
p vaut indépendamment 0 ou 1, r est un entier de 2 à 6, chacun de m et n est un entier de 1 à 90, la somme de m et n vaut de 2 à 180.

9. Dispositif électroluminescent selon l'une quelconque des revendications 1 à 8, dans lequel l'organohydrogénosiloxane fluoré (B) a au moins un groupe perfluoroalkyle monovalent, perfluorooxyalkyle monovalent, perfluoroalkylène divalent ou perfluorooxyalkylène divalent par molécule.

10. Utilisation d'une composition durcissable telle que définie dans l'une quelconque des revendications 1 à 9 pour l'encapsulation d'une diode électroluminescente d'un dispositif électroluminescent.
